# EUROPEAN PATENT APPLICATION

(11) **EP 0 930 656 A2**
(43) Date of publication of application: **21.07.1999**
(21) Application number: 98310793.9
(22) Date of filing: 30.12.1998
(51) Int. Cl.: H01L 27/115, H01L 21/8247

(54) **Flash memory region and method of fabrication thereof**

(30) Priority: 30.12.1997 US 70034 P
(71) Applicant: TEXAS INSTRUMENTS INC., Dallas, Texas 75243 (US)
(72) Inventor: Kaya, Cetin, Dallas, Texas 75243 (US); San, Kemal Tamer, Plano, Texas 75075 (US)
(74) Representative: Potter, Julian Mark

(57) **Abstract**

In accordance with the present invention, a flash memory region of a memory device (20) includes a silicon substrate (22), a plurality of memory stacks (26) formed on the silicon substrate (22). A moat (42) is formed between at least two of the plurality of memory stacks (26), with the silicon substrate (22) being exposed in the moat (22). A sidewall spacer (40) formed on each of the opposing sidewalls of each of the stacks adjacent the moat. Each of the stack (26) is encapsulated by dielectric (48). A dielectric layer (48) overlies the encapsulated stacks (26), and forms a slot-shaped contact aperture (14) therein exposing the silicon substrate in each of the moats (42). The aperture (14) has an elongated shape and extends transversely with the moat. A metal line (52) is positioned in the contact aperture to extend over the stacks and into the moat, and is in electrical contact with the silicon substrate (20) to form a continuous electrically conduction runner. A delectric layer (54) overlies the metal line to encapsulate the metal line (52).

## Description

### FIELD OF THE INVENTION

This invention relates to improvements in semiconductor processing techniques, and more particularly to improved semiconductor structures and associated methods for making semiconductor structures, or the like, and still more particularly, but not exclusively, to improvements in a semiconductor structure, and associated method of making, of self-aligned contact and first metal slots for flash memories.

### BACKGROUND OF THE INVENTION

Standard flash memory fabrication techniques create unacceptably variable and high contact resistance due to inconsistent contact area. The contacts are also not always self-aligned, making patterning and etching of the contact apertures very difficult. In addition, the bitline pitch is often limited by the present flat layer metal patterning and etch techniques.

Standard flash memory fabrication techniques use non self-aligned contacts. To scale the flash cells to smaller dimensions, one needs to scale the contacts and place them closer to the stacks. One of the factors in further scaling the contacts is the stepper alignment capabilities in patterning the contacts. However, stepper alignment capability is not scaling as fast as desired. As a result, contact apertures formed during contact etch processes can hit the sidewall spacer (next to stack) and create non-uniform, small contacts apertures.

What is needed is a memory structure that allows increased bitline and wordline density and provide consistent contact resistance.

It is with the foregoing problems in mind that the instant invention was developed.

### SUMMARY OF THE INVENTION

An embodiment of the present invention concerns flash memory structure, and specifically a self-aligned contact and first metal slot structure, and associated method for making.

It is an aim of an embodiment of the present invention to establish uniform contact areas, and smaller wordline pitch, by placing contacts closer to the stack.

It is also an aim of an embodiment of the present invention to simplify the lithography process at the contact level by providing slots (for consistent and continuous line spacing) rather than holes.

In addition, it is an aim of an embodiment of the present invention to make bitline pitch not limited by metal pattern and etch processes, but instead, to be limited by oxide pattern and etch processes which can be further scaled.

In accordance with an embodiment of the present invention, a flash memory region of a memory device includes a silicon substrate, a plurality of memory stacks formed on the silicon substrate, each of the stacks including a gate electrode, a control electrode, a first dielectric layer formed on the control electrode, and a second dielectric layer formed on the oxide layer, the stack having opposing sidewalls. A moat (active area) is formed between at least two of the plurality of memory stacks. A sidewall spacer is made of the second dielectric material, the sidewall spacer formed on each of the opposing sidewalls of each of the stacks adjacent the moat. Each of the stacks is encapsulated by the second layer of dielectric. A third dielectric layer overlies the encapsulated stacks. The contact aperture is formed transverse to the stacks, and a contact area exposes the silicon substrate in each of the moats. The aperture has a slot shape and extends co-extensively with the moat and over the stacks. The contact area has two opposing sides formed by the sidewall spacer, and two opposing sides formed of the third dielectric layer. A metal line is positioned in the contact aperture, and is in electrical contact with the silicon substrate in the contact area to form an electrically conductive runner along the moat. A fourth dielectric layer overlies the metal line to encapsulate the metal line.

In light of the above, therefore, an embodiment of the invention seeks to establish a self-aligned contact and first layer metal slot process for flash memories to further scale the memory cell, both in wordline pitch by forming a self-aligned contact structure, and bitline pitch (first metal layer slots).

These and other features, and advantages of embodiments of the invention will become apparent to those skilled in the art from the following detailed description provided by way of example only, when read in conjunction with the accompanying drawings and appended claims.

### BRIEF DESCRIPTION OF THE DRAWINGS

Fig. 1 is a plan view of the flash memory region of a semiconductor device.
Fig. 2a is a section view taken along line 2a-2a of Fig. 1.
Fig. 2b is a section view taken along tine 2b-2b of Fig. 1.
Figs. 3-7 are representative section views of the flash memory region of the present invention during various stages of fabrication.

### DETAILED DESCRIPTION OF THE PREFERRED EMBODIMENT

It should be noted that the process steps and structures herein described do not necessarily form a complete process flow for manufacturing integrated circuits. It is anticipated that embodiments of the present invention may be practiced in conjunction with integrated circuit fabrication techniques currently used in the art and in the future, and only so much of the commonly practiced process steps are included as are necessary for an understanding of embodiments of the present invention. It will be apparent to those skilled in the art that the invention is also applicable to various integrated circuit processes, structures, and devices.

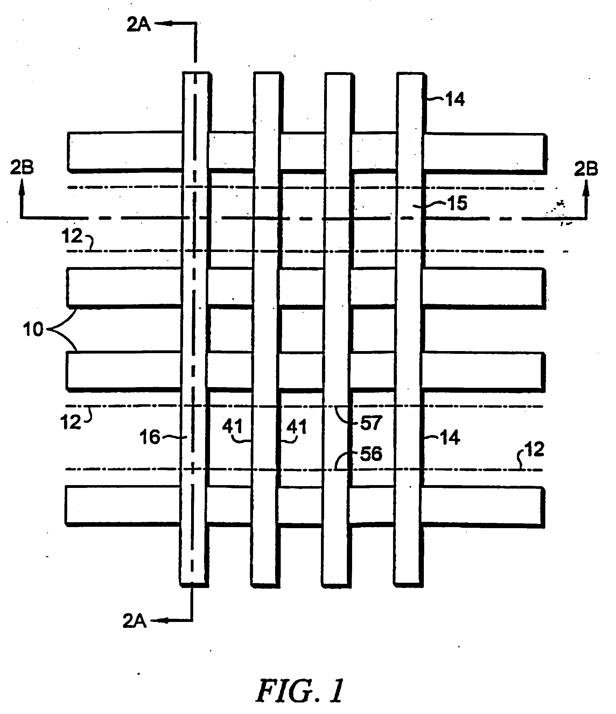

In general, but not necessarily, the process is practiced on conventional flash memory structure, as shown in top view in Fig. 1. This conventional flash memory stack structure includes a plurality of laterally extending stack structures 10 with sidewall spacers 12 shown extending from the sidewalls of some of the stacks. Moats (active area) 15 are formed on the silicon substrate between each of the stacks 10, as described below. A plurality of contact slot apertures 14 are formed over and transverse to the stacks, and define contact areas 15 between the stacks 10 after the contact etch step. These features are formed through dielectric material. A conductive layer 16, such as metal, is positioned in each of the slots 14 to contact the moat 15. Each contact area 15 is approximately 0.4 to 0.5 microns in length and approximately 0.32 microns wide. These dimensions can be larger or smaller as desired for a particular application.

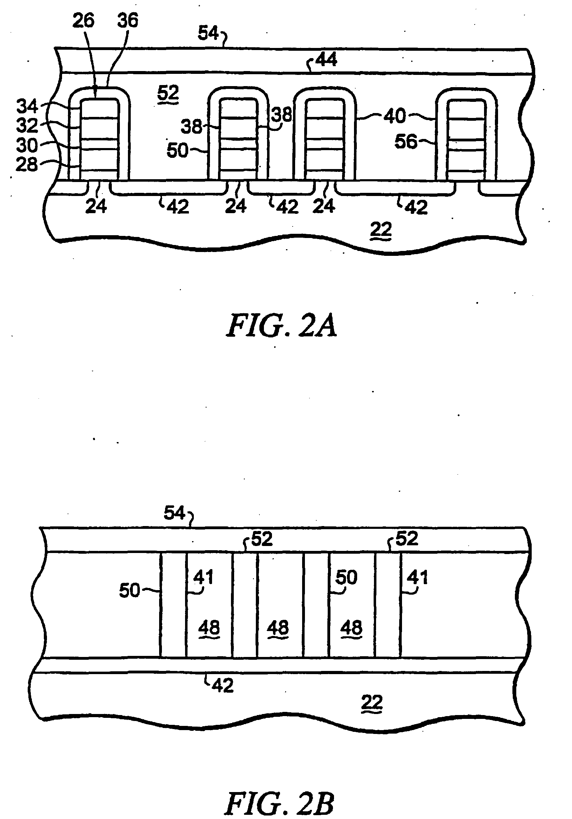

Figs. 2(a) and (b) each show a sectional view of a memory cell of a flash memory device. Fig. 2(a) is transverse to the longitudinal orientation of the bitlines. Fig. 2(b) is taken transverse to Fig. 2(a). The flash memory device 20 in Fig. 2(a) is formed on a P- lightly doped silicon semiconductor substrate 22. A tunnel oxide layer 24 comprising silicon oxide (SiO₂) has been formed on the top surface of the semiconductor substrate 22. The stack 26 is formed over the tunnel oxide layer 24, and from the bottom up comprises a floating gate electrode 28, an ONO integrate dielectric layer 30, control gate electrode 32, an oxide layer 34, and a layer of silicon nitride 36 (Si₃N₄). Each of the stacks 26 define owing sidewalls 38 of continuous layers of the above structure. A nitride sidewall spacer 40 is formed on the opposing sidewalls 38 in conjunction with the top layer 36 of nitride. The sidewall spacers 40 are preferably between 1000 to 2000 Å at their base, and act to isolate the stack 26 from surrounding structures.

Adjacent stacks are separated by a distance, and can be close enough together, such as at 44, to effectively include a common sidewall spacer. N+ doped source and drain regions 42, or moats, are formed in the silicon substrate, between adjacent stacks and extend under the stack 26 to some extent, as is known in the art. Source and drain regions are ion implanted with a implant concentration of approximately 10E20 atoms per cubic centimeter. The source and drain implant regions 42 are formed before the formation of the sidewall spacers 40.

Self-aligned contact areas 50 are formed between the sidewall spacers 40 of adjacent stacks 26, over the moats. A first metal layer 52 is positioned in the contact aperture 14, and extends into the contact area 50 (same as 15 in Fig. 1) to contact the exposed silicon substrate 22 (moat). The first metal layer 52 continuously extends over the stacks and down to the contact areas 50, forming a bitline. The metal 52 in the contact area 50 is in contact with the silicon substrate 22, the sidewalls 40 and BPSG sidewalls 41 (see Fig. 2(b)) of the self-aligned contact. Openings (not shown) to the first metal 52 are formed through the ILD 54 as necessary by standard pattern and etch processes to allow electrical connection between the first layer metal 52 and the upper conductive layers. In Fig. 2(b), the metal layers 52 are shown separated and electrically isolated from one another by BPSG or other dielectric layer, all along the same moat 42, as is described in greater detail below.

The pitch of the memory stacks 26 is able to be built with 1.07 micron spacing, as opposed to the 1.15 micron spacing of previous memory regions. These dimensions can be scaled down as desired for a given design

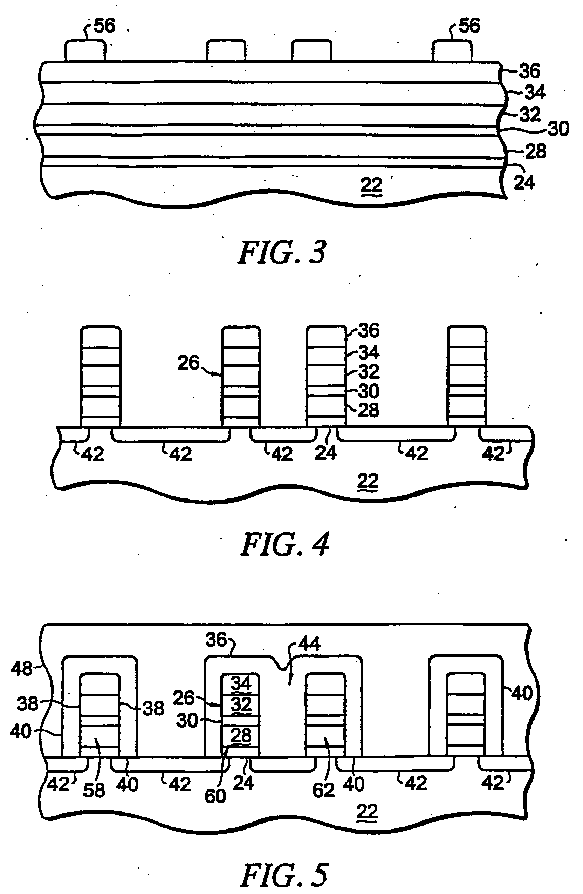

The formation of the memory stack 26 and bitline structure is described in conjunction with Figs. 3 through 7. In forming the conventional flash stack, a layer of tunnel oxide 24 is formed on the top surface of the silicon substrate 22. The tunnel oxide 24 has a thickness of approximately 80 to 120 A. A first layer of doped polysilicon 28 is formed on the top surface of the tunnel oxide 24. The first polysilicon layer 28 forms the floating gate electrode, and is approximately 1200 to 1500 A thick. A layer of ONO 30 is then formed on the first

Pursuant to an embodiment of the instant invention, two additional layers are formed on the gate electrode stack, including the first dielectric layer 34, formed on the upper surface of the control electrode 32, and which is approximately 3000 A thick. Preferably, the oxide is tetraethylorthosilicate (TEOS). Additionally, a second dielectric layer 36, such as a nitride layer, is formed on top of the first dielectric layer 34 and is approximately 2000 A thick. These layers are deposited using known deposition techniques.

The stack of materials is patterned with a photoresist 56 and then anisotropically etched to from the individual stacks 26. The etch process is adjusted to effectively etch through each of the six layers of material formed on the Si substrate 22, and to stop on the Si substrate to minimize any damage thereto. The photoresist pattern 56 is shown in Fig. 3, and the resulting stacks 26 and interpositioned moats 42 formed during the etch step are shown in Fig. 4. The moats are then formed in the Si exposed between the stacks. The moats are the doped regions formed by a source/drain implant. An N+ implant concentration of 10²⁰ atoms per cubic centimeter is acceptable.

The individual memory stack structures 26 are then isolated by complete encapsulation of each stack in nitride, as shown in Fig. 5. The nitride encapsulation is obtained by first depositing a layer of nitride having sufficient thickness to conformally cover the sidewalls 38 of each stack 26, even between closely spaced stacks: A nitride thickness of approximately 2500 Å is satisfactory. The nitride is then etched back using an anisotropic etch chemistry selective against silicon to expose the underlying silicon 22 where desired (at moat 42), and also leave a sufficiently thick layer of nitride on the sidewalls 38 of the memory stack 26, as shown in Fig. 5. The etch-back results in the formation of nitride sidewall spacers on either side of the stacks 26 spaced sufficiently apart from adjacent stacks. As shown in Fig. 5, the distance between stack 58 and stack 60 is approximately 0.82 microns, allowing the formation of the sidewall spacers 40 and of exposure of the Si substrate 22 at the moat 42 between the two stacks. Where the distance between stacks is less, such as between stacks 60 and 62 at space 44, the nitride completely fills the moat therebetween, and no Si substrate is exposed during the nitride etch-back process step which forms the sidewall spacers 40 elsewhere.

As shown in Fig. 5, a third layer 48 of dielectric, such as borophosphorous silicate glass (BPSG) is then deposited to a thickness of approximately 6000Å, and is reflowed to create a low-relief coverage of the memory stacks 26. The BPSG glass forms a planarized layer to more easily allow the subsequent formation of contact slots 50 therethrough, as next described.

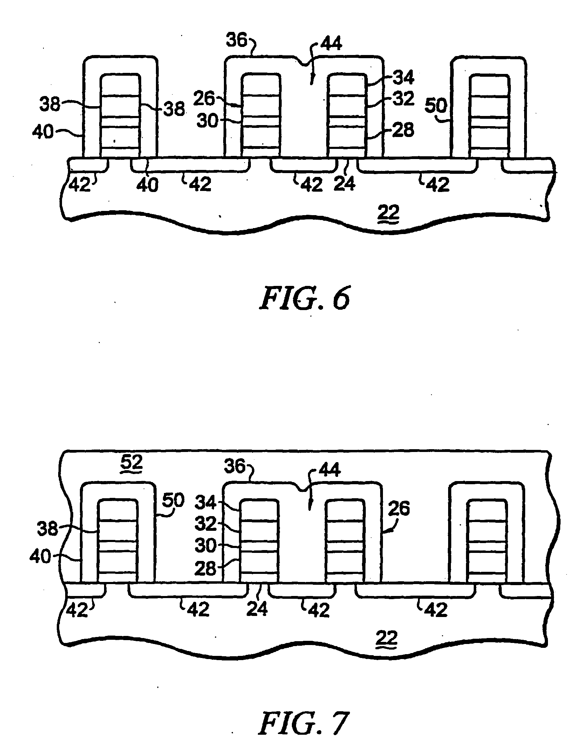

Next, contact slot apertures 14 (Fig. 1) are formed through the BPSG layer 48 in the memory array by patterning and etching the reflowed BPSG layer. The contact slot apertures are elongated and run transverse to the stacks. The slots 50 are shown in Fig. 6 after formation. The contact slots 50 are patterned to run over the moat regions 42, are parallel to the moat regions, and run along the moat regions, between the stacks. The contact slots are separated by inter-positioned portions of the layer 48. In etching the contact slots 14, an anisotropic etch chemistry is used that is selective to nitride and to Silicon. This type of etch chemistry causes the etch process to stop on the nitride layer of the stack, and on the silicon in the moat region 42 (forming the contact areas 50). Thus, the contact aperture exposes the silicon substrate between the stacks (the contact area 50) and the nitride over the stacks. Several etch chemistries could be used, including the preferred chemistry utilizing C₄F₈, CO, CF₄, and CHF₃. The contact areas 50 are thus self-aligned to the stacks 26, as shown in Fig. 6, where the nitride spacer 40 is exposed during the contact etch without detrimental effect to the device performance. The layer 48 is removed entirely from the stack regions where exposed during the etch.

The contact areas 50 have one pair of opposing edges 57 formed of nitride (from the sidewall spacers 40 (see Figs. 1 and 2(a)), and the other pair of opposing edges 41 formed of BPSG layer 48 (see Figs. 1 and 2(b)). The contact slot areas 50 are thus square or rectangular, as opposed to circular or oval. The square or rectangular shape is more easy to efficiently pattern in photoresist in comparison to circular or oval apertures. Since the photoresist patterning is better, the resulting aperture structure is more consistently formed in the etch step. The BPSG 48 is entirely removed from the nitride 36 and 40 on the stacks 26 where exposed to the etch, and from the moat 42. The contact slots 50 have a dimension of approximately 0.32 microns, between nitride edges, a dimension of approximately 0.4 microns between BPSG edges 41, and a thickness of approximately 10,000 Å.

The contact apertures 14 (Fig. 1) are then filled with a metal 52, such as Tungsten (W), for conformal deposition, or force-filled with Aluminum or other suitable metal. The metal 52 in the contact areas 50 makes electrical contact with the silicon substrate 22. This structure is shown in Fig. 7. The metal lines 52 filling the contact apertures 14 form bitlines running through the memory region of the device. The metal 52 is initially deposited to a thickness of approximately 5000 Å.

The metal 52 is then anisotropically etched-back to the top of the BPSG reflow layer 48 using an anisotropic etch process or a chemical-mechanical polish step. The metal lines are thus separated by BPSG (Fig. 2b) and run continuously along the contact aperture 14 (over stacks and down in to contact areas 50). The metal lines 52 thus effectively plug the contact apertures 50 and run parallel thereto. There is metal only in the contact apertures 14, and not on the BPSG. The metal etch chemistry can be any suitable etch chemistry known in the art which is relatively selective to the third dielectric layer 48.

The metal line 52 is then covered with a fourth layer of inter-layer dielectric (ILD) material 54, such as 3000 Å of PTEOS, 4000 Å of SOG, and 3000Å of PTEOS, as shown in Fig. 2. This fourth layer of ILD material is approximately 10,000 Å thick. The bitlines in the contact area thus contact the Si substrate 22 on their bottom surface, and the BPSG 48 and nitride 40 on their side surfaces. Inter-metal via can be formed on the fourth dielectric layer to contact the metal 52 as desired for further processing.

The bitlines form electrical contact to drain regions, and it is easier to print rectangular or square slots 14 than to print circular or oval contact holes.

Some advantages of this structure and related process is that the self-aligned contact area to the moat is constant, creating very minimal contact resistance variation. This is a very beneficial feature, since for example CHE (channel hot electron) programming draws about 0.5 ma/bit, providing strong incentive to maintain low contact resistance. In addition, the bitline pitch is not limited as it is with normal first layer metal processes. Bitline metal spacing is defined by a pattern over oxide and etch steps. This allows the bitline pitch to be pushed close to its minimum 2f (feature size). Some increase in bitline-to-bitline and bitline-to-wordline capacitances could be seen because the bitlines are closer together, but not significantly enough to pose a performance problem.

While this invention has been described with reference to the illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely in the specific combinations enumerated in the claims.

## Claims

1. A flash memory region of a memory device comprising:
a silicon substrate;
a plurality of memory stacks formed on said silicon substrate, each of said stacks including a gate electrode, a control electrode, a first dielectric layer formed on said control electrode, and a second dielectric layer formed on said oxide layer, said stack having opposing sidewalls;
a moat formed between at least two of said plurality of memory stacks, said silicon substrate exposed in said moat;
a sidewall spacer made of said second dielectric material, said sidewall spacer formed on each of said opposing sidewalls of each of said stack adjacent said moat, each of said stacks being encapsulated by said second layer of dielectric;
a third dielectric layer overlying said encapsulated stacks;
a contact aperture, having a contact area exposing said silicon substrate of each of said moats, said aperture having a slot shape and running transversely with said moat and said plurality of stacks;
a metal line positioned in said contact aperture and in electrical contact with said silicon substrate to form a continuous electrically conductive runner, and
a fourth dielectric layer overlying said metal line.

2. A flash memory structure as defined in Claim 1, wherein said metal line is encapsulated by said second, third and fourth dielectrics.

3. A flash memory structure as defined in Claim 1 or 2, wherein said first dielectric is TEOS.

4. A flash memory structure as defined in any of Claims 1 to 3, wherein said second dielectric is nitride.

5. A flash memory structure as defined in any of Claims 1 to 4, wherein said third dielectric is BPSG.

6. A flash memory structure as defined in any of Claims 1 to 5, wherein said fourth dielectric is a multiple layer sandwich of plasma TEOS, SOG, and plasma TEOS.

7. A flash memory structure as defined in any of Claims 1 to 6, wherein said metal line is tungsten.

8. A flash memory structure as defined in any of Claims 1 to 6, wherein said metal line is aluminum.

9. A method of fabricating a flash memory region of a memory device comprising the steps of:
providing a silicon substrate;
forming a plurality of memory stacks formed on said silicon substrate, each of said stacks including a gate electrode, a control electrode, a first dielectric layer formed on said control electrode, and a second dielectric layer formed on said oxide layer, said stack having opposing sidewalls;
forming a moat between at least two of said plurality of memory stacks;
forming a sidewall spacer made of said second dielectric material, said sidewall spacer formed on each of said opposing sidewalls of each of said stack adjacent said moat, each of said stacks being encapsulated by said second layer of dielectric;
overlying said encapsulated stacks with a third dielectric layer;
forming a contact aperture extending transversely to said moat and said stacks, which exposes said moat, said aperture having a elongated slot shape;
depositing a metal line in said contact aperture in electrical contact with said moat to form a electrically conductive runner extending transversely to said moat and said stacks; and
overlying said metal line with a fourth dielectric to encapsulate said metal line.

10. A flash memory region of a memory device comprising:
a silicon substrate;
a plurality of memory stacks formed on said silicon substrate, each of said stacks including a gate electrode, a control electrode, a first dielectric layer formed on said control electrode, and a second dielectric layer formed on said oxide layer, said stack having opposing sidewalls;
a moat formed between at least two of said plurality of memory stacks, said silicon substrate exposed in said moat and being doped;
a sidewall spacer made of said second dielectric material, said sidewall spacer formed on each of said opposing sidewalls of each of said stack adjacent said moat, each of said stacks being encapsulated by said second layer of dielectric;
a third dielectric layer overlying said encapsulated stacks;
a contact aperture exposing said doped silicon substrate in each of said moats, said aperture having an elongated slot shape and running transversely to said moat and said stacks;
a metal line positioned in said contact aperture and in electrical contact with said silicon substrate in said moat to form a continuous electrically conductive runner; and
a fourth dielectric layer overlying said metal line to encapsulate the metal line.
